Europäisches Patentamt

European Patent Office

Office européen des brevets

(19)

(11) Veröffentlichungsnummer: **0 075 112**
A2

(12) **EUROPÄISCHE PATENTANMELDUNG**

(21) Anmeldenummer: 82107471.3

(22) Anmeldetag: 17.08.82

(51) Int. Cl.³: **H 03 K 17/945,** H 01 H 9/02

(30) Priorität: 17.09.81 DE 3136994

(43) Veröffentlichungstag der Anmeldung: 30.03.83
Patentblatt 83/13

(84) Benannte Vertragsstaaten: AT BE CH FR GB IT LI LU NL SE

(71) Anmelder: i f m electronic gmbh, Teichstrasse 4, D-4300 Essen 1 (DE)

(72) Erfinder: Neuhaus, Wolfgang, Werdohler Landstrasse 211, D-5880 Lüdenscheid (DE)

(74) Vertreter: Gesthuysen, Hans Dieter, Dipl.-Ing. et al, Patentanwälte Gesthuysen + von Rohr Huyssenallee 15 Postfach 10 13 33, D-4300 Essen 1 (DE)

(54) Schaltgerät, insbesondere elektronisches, berührungslos arbeitendes Schaltgerät, mit zylindrischem Gehäuse.

(57) Dargestellt und beschrieben ist ein Schaltgerät, das aus einem im wesentlichen zylindrischen Gehäuse, aus in dem Gehäuse vorgesehenen und zu einer elektrischen Schaltung miteinander verbundenen elektrischen und/oder elektronischen Bauelementen, zu denen mindestens ein Beeinflussungselement gehört, und aus einer Anschlußeinrichtung zum Anschluß eines Kabels besteht. Das Gehäuse weist einen Beeinflußungsbereich, einen Schaltungsbereich und einen Anschlußbereich auf und besteht aus zwei Gehäuseteilen (9, 10), wobei die Gehäuseteile (9, 10) einander zugewandte, unter einem spitzen Winkel zur Gehäuselängsachse verlaufende Begrenzungsflächen (12, 13) aufweisen. Ein Gehäuseteil (9) weist im Bereich der einander zugewandten Begrenzungsflächen (12, 13) eine senkrecht zur Begrenzungsfläche (12) stehende Gewindebohrung (14) auf, während das andere Gehäuseteil (10) eine Aufnahme (15) für eine in die Gewindebohrung (14) einzuschraubende Verbindungsschraube (16) aufweist. Die elektrische Schaltung weist ein einstellbares bzw. abstimmbares elektrisches oder elektronisches Bauelement (21) auf, das über ein Einstellelement (22) einstellbar ist. Um die Betätigung des Einstellelementes (22) zu ermöglichen, ist die Gewindebohrung (14) durch die Wandung (19) des entsprechenden Gehäuseteiles (9) hindurchgeführt und ist das Einstellelement (22) durch die Gewindebohrung (14) hindurch betätigbar.

Die Erfindung betrifft ein Schaltgerät, insbesondere elektronisches, berührungslos arbeitendes Schaltgerät, bestehend aus einem im wesentlichen zylindrischen Gehäuse, aus in dem Gehäuse vorgesehenen und zu einer elektrischen Schaltung miteinander verbundenen elektrischen und/oder elektronischen Bauelementen, zu denen mindestens ein Beeinflussungselement gehört, und ggf. aus einer Anschlußeinrichtung zum Anschluß eines Kabels, wobei das Gehäuse einen Beeinflussungsbereich, einen Schaltungsbereich und einen Anschlußbereich aufweist und aus mindestens zwei Gehäuseteilen besteht, wobei die Gehäuseteile einander zugewandte, unter einem spitzen Winkel zur Gehäuselängsachse verlaufende Begrenzungsflächen aufweisen und wobei ein Gehäuseteil im Bereich der einander zugewandten Begrenzungsflächen eine senkrecht zur Begrenzungsfläche stehende Gewindebohrung und das andere Gehäuseteil eine Aufnahme für eine in die Gewindebohrung einzuschraubende Verbindungsschraube aufweist.

Bei dem bekannten Schaltgerät, von dem die Erfindung ausgeht (vgl. die DE-AS 27 58 969), ist das Gehäuse kreiszylindrisch ausgeführt und besteht aus drei Gehäuseteilen. Die Begrenzungsflächen der Gehäuseteile verlaufen bei diesem Schaltgerät unter einem Winkel von 45° zur Gehäuselängsachse.

Zu der elektrischen Schaltung des zuvor erläuterten bekannten Schaltgerätes gehören neben dem Beeinflussungselement, das eine Ansprechspule, eine Ansprechelektrode, eine Ansprechoptoelektronik mit einem Lichterzeuger und einem Lichtempfänger usw. sein kann, noch verschiedene weitere elektrische bzw. elektronische Bauelemente. Zu diesen elektrischen oder elektronischen Bauelementen gehören je nach Ausführungsform der elektrischen Schaltung auch einstellbare bzw. abstimmbare elektrische oder elektronische Bauelemente. Die Einstellung bzw. Abstimmung dieser einstellbaren bzw. abstimmbaren Bauelemente kann werksseitig erfolgen. Erfolgt die Einstellung bzw. Abstimmung werksseitig, so ist es schwierig, diese werksseitig vorgegebene Einstellung bzw. Abstimmung betriebsmäßig zu ändern. Zumindest erfordert eine betriebsmäßige Einstellung bzw. Abstimmung ein Zerlegen des Schaltgerätes, mitunter ist eine betriebsmäßige Einstellung bzw. Abstimmung auch gar nicht möglich, da die entsprechenden Bauelemente in dem Gehäuse vergossen sind.

Ist es notwendig, ein einstellbares bzw. abstimmbares Bauelement (oder mehrere derartige Bauelemente) auch betriebsmäßig noch einzustellen bzw. abzustimmen, so ist es bekannt (vgl. das DE-GM 66 02 341), eine zusätzliche Einstellöffnung in dem Gehäuse des Schaltgerätes vorzusehen, das einzustellende bzw. abzustimmende Bauelement nächst dieser Einstellöffnung anzuordnen und das Einstellelement des einzustellenden bzw. abzustimmenden Bauelementes von außen her durch die Einstellöffnung zu betätigen. Das Vorsehen derartiger zusätzlicher Einstellöffnungen in dem Gehäuse erfordert einen ergänzenden fertigungstechnischen Aufwand.

Im übrigen müssen derartige Schaltgeräte je nach dem Einsatzzweck bestimmten anwendungs- und sicherheitstechnischen Anforderungen entsprechen. So muß beispielsweise relativ häufig das Innere derartiger Schaltgeräte wegen des speziellen Einsatzzweckes gegenüber der Umgebung gas- und/oder flüssigkeitsdicht, insbesondere säuredicht, abgeschottet sein. Insbesondere in diesen Fällen stören zusätzlich vorhandene Einstellöffnungen, die stets besondere Abdichtmaßnahmen erfordern.

Ausgehend von dem zuvor erläuterten Stand der Technik liegt der Erfindung nun die Aufgabe zugrunde, das bekannte, eingangs erläuterte Schaltgerät so auszugestalten und weiterzubilden, daß auf herstellungs-, anwendungs- und sicherheitstechnisch einfache Weise eine betriebsmäßige Einstellbarkeit bzw. Abstimmbarkeit eines einstellbaren bzw. abstimmbaren Bauelementes der elektrischen Schaltung möglich ist.

Das erfindungsgemäße Schaltgerät, bei dem die zuvor aufgezeigte Aufgabe gelöst ist, ist nun dadurch gekennzeichnet, daß die Gewindebohrung durch die Wandung des entsprechenden Gehäuseteiles hindurchgeführt ist, daß an dem dem Inneren des Gehäuseteiles zugewandten Ende der Gewindebohrung ein elektrisches oder elektronisches, einstellbares bzw. abstimmbares Bauelement der elektrischen Schaltung angeordnet ist, daß das Bauelement ein Einstellelement aufweist und daß das Einstellelement durch die Gewindebohrung hindurch betätigbar ist. Erfindungsgemäß ist erkannt worden, daß bei dem in Rede stehenden Schaltgerät sowieso zwingend eine Gewindebohrung vorhanden ist, nämlich

Gesthuysen & von Rohr

die Gewindebohrung, in die die Verbindungsschraube zur Verbindung der beiden Gehäuseteile eingeschraubt wird. Erfindungsgemäß ist nun weiter erkannt worden, daß ohne herstellungstechnischen Mehraufwand diese Gewindebohrung als Durchgangsbohrung ausgeführt werden kann und daß dann diese Gewindebohrung praktisch gleichzeitig als zusätzliche Einstellöffnung zur Betätigung des Einstellelementes eines einstellbaren bzw. abstimmbaren Bauelementes dienen kann. Dies ist auch sicherheitstechnisch eine glänzende Lösung, da im Bereich der Begrenzungsflächen der Gehäuseteile sowieso zusätzliche Dichtungsmittel vorgesehen sein müssen, so daß auch die sicherheitstechnischen Anforderungen in diesem Bereich mit einem nur sehr geringen Mehraufwand erfüllt werden können.

Die Einstellung bzw. Abstimmung des einstellbaren bzw. abstimmbaren Bauelementes ist natürlich davon abhängig, um was für ein Bauelement es sich hier handelt. In den meisten Fällen wird es sich allerdings bei dem Bauelement um ein Potentiometer handeln, wobei als Einstellelement des Bauelementes eine Einstellschraube vorgesehen ist. Das einstellbare bzw. abstimmbare Bauelement kann aber auch beispielsweise ein Schalter sein, wobei dann das Einstellelement beispielsweise eine Drucktaste sein kann. In jedem Fall sollte das Einstellelement des elektrischen oder elektronischen Bauelementes in die Gewindebohrung hineinragen. Letzteres erleichtert die zielsichere Betätigung des Einstellelementes.

Was die Abdichtung des Inneren des Gehäuseteiles betrifft, in dem das einstellbare bzw. abstimmbare Bauelement angeordnet ist, so kann diese Abdichtung grundsätzlich im Bereich des Kopfes der Verbindungsschraube erfolgen. Dann aber ist die Abdichtung nur gegeben, wenn die Verbindungsschraube tatsächlich in die Gewindebohrung eingeschraubt ist. Unabhängig von der Verbindungsschraube ergibt sich eine gute Abdichtung des Inneren des entsprechenden Gehäuseteiles dann, wenn das Innere des Gehäuseteiles gegenüber der Gewindebohrung über das elektrische oder elektronische Bauelement selbst abgedichtet ist. Dazu kann beispielsweise zwischen dem Bauelement und der Wand des Gehäuseteiles im Bereich um das Ende der Gewindebohrung herum ein Dichtring angeordnet sein. Ist ein Dichtring vorgesehen, so muß allerdings das Bauelement mit einem Mindestdruck an die Wandung des Gehäuseteiles angepreßt werden, was zusätzlich konstruktive Maßnahmen erfordert. Dementsprechend
ist es besonders vorteilhaft, wenn das elektrische oder elektronische Bauelement mit der Wandung des Gehäuseteiles im Bereich um das Ende der Gewindebohrung herum verklebt ist. Einerseits wird durch dieses Verkleben das Bauelement an dem Gehäuseteil fixiert, andererseits wird eine sichere Abdichtung
gewährleistet.

Zuvor ist erläutert worden, daß und wie das Einstellelement des einstellbaren
bzw. abstimmbaren elektrischen oder elektronischen Bauelementes durch die Gewindebohrung hindurch betätigt werden kann. Diese Betätigung des Einstellelementes des elektrischen oder elektronischen Bauelementes erfordert ein Entfernen der Verbindungsschraube. Mit dem Entfernen der Verbindungsschraube
besteht dann aber die Gefahr, daß die Gehäuseteile des Gehäuses sich ungewollt voneinander lösen, was aus sicherheitstechnischen Gründen mitunter verhindert werden muß. In diesem Fall ist es vorteilhaft, wenn an den Gehäuseteilen im Bereich der einander zugewandten Begrenzungsflächen ergänzende Verbindungselemente vorgesehen sind. Als ergänzende Verbindungselemente kommen
beispielsweise in Sack-Gewindebohrungen eingreifende Verbindungsschrauben
in Frage. Als besonders zweckmäßig hat es sich hier aber erwiesen, die Verbindungselemente als koaxial zu der Gewindebohrung und der Aufnahme für die
Verbindungsschraube angeordnete Rastelemente auszuführen. Über diese als
Rastelemente ausgeführten Verbindungselemente werden die Gehäuseteile ausreichend fest aneinander gehalten, um die notwendige Abdichtung aufrechtzuerhalten.

Auf die zusätzlichen ergänzenden Verbindungselemente könnte man verzichten,
wenn man die Verbindungsschraube zum Einstellen bzw. Abstimmen des einstellbaren bzw. abstimmbaren Bauelementes nicht entfernen müßte. Hier geht nun
eine weitere Lehre der Erfindung, der ganz besondere Bedeutung zukommt, dahin,
die Verbindungsschraube als Hohlschraube mit in Längsrichtung verlaufender
Durchgangsbohrung auszuführen. Mit dieser Ausgestaltung der Verbindungsschraube ist gewährleistet, daß das Einstellelement des elektrischen oder elektronischen Bauelementes jederzeit frei zugänglich ist, ganz unabhängig davon,
was mit der Verbindungsschraube los ist.

Was die weitere Ausgestaltung des erfindungsgemäßen Schaltgerätes betrifft,
so kann sich diese im Rahmen dessen halten, was aus dem Stand der Technik
schon bekannt ist. Um hier allzu ausgreifende Erläuterungen vermeiden zu
können, wird ergänzend auf die DE-ASen 27 13 213 und 27 58 959 verwiesen, deren Offenbarungsgehalt hiermit ausdrücklich auch zum Offenbarungsgehalt der
vorliegenden Patentanmeldung gemacht wird.

Im folgenden wird die Erfindung nun anhand einer lediglich Ausführungsbeispiele darstellenden Zeichnung näher erläutert; es zeigt

Fig. 1      in perspektivischer Darstellung ein Ausführungsbeispiel eines erfindungsgemäßen Schaltgerätes,

Fig. 2      einen Schnitt durch das Schaltgerät nach Fig. 1 entlang der
            Linie II - II und  .

Fig. 3      ein zweites Ausführungsbeispiel eines erfindungsgemäßen Schaltgerätes im Teilschnitt entsprechend der Darstellung in Fig. 2.

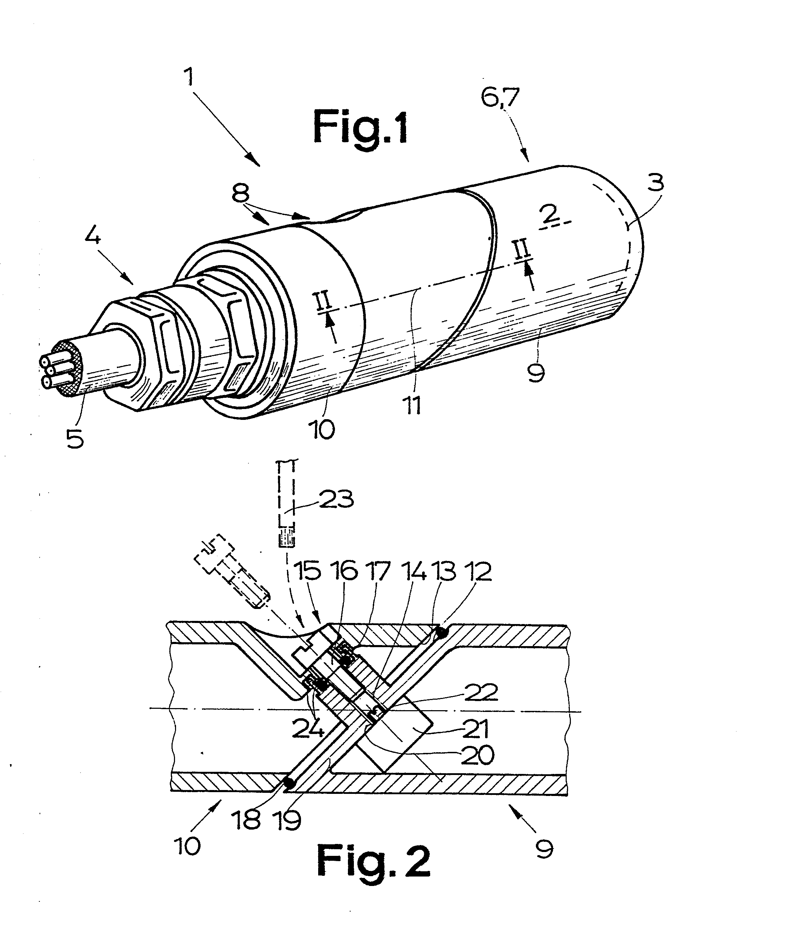

Das in Fig. 1 dargestellte Schaltgerät ist ein elektronisches, berührungslos
arbeitendes Schaltgerät und besteht im dargestellten Ausführungsbeispiel aus
einem im wesentlichen kreiszylindrischen Gehäuse 1, aus in dem Gehäuse 1 vorgesehenen und zu einer nur angedeuteten elektrischen Schaltung 2 miteinander
verbundenen elektrischen und/oder elektronischen, im einzelnen nicht dargestellten Bauelementen, zu denen ein Beeinflussungselement 3 gehört, im dargestellten Ausführungsbeispiel eine Ansprechelektrode, und aus einer Anschlußeinrichtung 4 zum Anschluß eines Kabels 5. Das Gehäuse 1 weist einen
Beeinflussungsbereich 6, einen Schaltungsbereich 7 und einen Anschlußbereich 8 auf. Beeinflussungsbereich 6, Schaltungsbereich 7 und Anschlußbereich 8 des Gehäuses 1 bezeichnen die Bereiche des Gehäuses 1, in denen das
Beeinflussungselement 3, die elektrische Schaltung 2 bzw. die Anschlußeinrichtung 4 ganz oder überwiegend vorgesehen sind. Das Gehäuse 1 besteht aus
zwei Gehäuseteilen 9, 10. Die Gehäuseteile 9, 10 weisen einander zugewandte,
unter einem spitzen Winkel, nämlich unter einem Winkel von 45$^O$, zur Gehäuse-

längsachse 11 verlaufende Begrenzungsflächen 12, 13 auf. Dabei stellt das
Gehäuseteil 9 den Beeinflussungsbereich 6 und den Schaltungsbereich 7 dar,
während das Gehäuseteil 10 den Anschlußbereich 8 darstellt.

Aus Fig. 2 ergibt sich, daß das Gehäuseteil 9 im Bereich der einander zugewandten Begrenzungsflächen 12, 13 eine senkrecht zur Begrenzungsfläche 12
stehende Gewindebohrung 14 aufweist. Das Gehäuseteil 10 weist im Bereich
der einander zugewandten Begrenzungsflächen 12, 13 eine Aufnahme 15 für eine
in die Gewindebohrung 14 einzuschraubende Verbindungsschraube 16 auf.

Im Bereich der einander zugewandten Begrenzungsflächen 12, 13 sind ferner
Dichtringe 17, 18 vorgesehen.

In dem in Fig. 2 dargestellten Ausführungsbeispiel ist die Gewindebohrung 14
in dem Gehäuseteil 9 durch die Wandung 19 des Gehäuseteiles 9 hindurchgeführt. An dem dem Inneren des Gehäuseteiles 9 zugewandten Ende 20 der Gewindebohrung 14 ist ein elektrisches oder elektronisches Bauelement 21 der elektrischen Schaltung 7 angeordnet. Dieses Bauelement 21 ist einstellbar bzw.
abstimmbar und weist dazu ein Einstellelement 22 auf. Das Einstellelement 22
des Bauelementes 21 ist durch die Gewindebohrung 14 hindurch betätigbar, und
zwar dann, wenn die Verbindungsschraube 16 aus der Gewindebohrung 14 und
der Aufnahme 15 herausgezogen ist, wie das in Fig. 2 gestrichelt angedeutet
ist.

Im dargestellten Ausführungsbeispiel ist das Bauelement 21 ein Potentiometer
und ist das Einstellelement 22 eine Einstellschraube, so daß die Einstellung
des Einstellelementes 22 mittels eines schmalen Schraubenziehers 23 erfolgen
kann, der in Fig. 2 gleichfalls gestrichelt angedeutet ist.

Das Einstellelement 22 ragt in die Gewindebohrung 14 hinein, so daß das Einstellelement 22 leicht zielsicher betätigt werden kann.

Gesthuysen & von Rohr

Wie Fig. 2 weiter zeigt, ist das Innere des Gehäuseteiles 9 gegenüber der Gewindebohrung 14 über das Bauelement 21 abgedichtet, ist nämlich das Bauelement 21 mit der Wandung 19 des Gehäuseteiles 9 im Bereich um das Ende 20 der Gewindebohrung 14 herum verklebt. Gleichzeitig ist durch dieses Verkleben das Bauelement 21 an der Wandung 19 des Gehäuseteiles 9 fixiert.

Um zu gewährleisten, daß die Gehäuseteile 9, 10 auch bei entfernter Verbindungsschraube 16 nicht auseinanderfallen, sind an den Gehäuseteilen 9, 10 im Bereich der einander zugewandten Begrenzungsflächen 12, 13 ergänzende Verbindungselemente 24 vorgesehen. Diese Verbindungselemente 24 sind, wie sich aus Fig. 2 ergibt, als koaxial zu der Gewindebohrung 14 und der Aufnahme 15 der Verbindungsschraube 16 angeordnete Rastelemente ausgeführt.

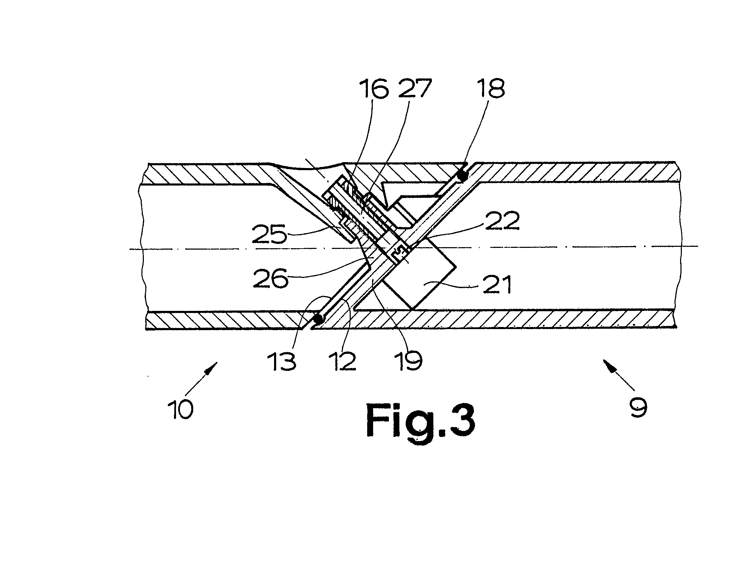

Das in Fig. 3 dargestellte Ausführungsbeispiel eines erfindungsgemäßen Schaltgerätes unterscheidet sich von dem in Fig. 2 dargestellten Ausführungsbeispiel zunächst dadurch, daß die Gehäuseteile 9, 10 im Bereich der einander zugewandten Begrenzungsflächen 12, 13 einerseits eine Nut 25, andererseits eine Feder 26 aufweisen. Die Nut 25 und die Feder 26 sind so ausgeführt und angeordnet, daß über die Nut 25 und die Feder 26 in jeder zulässigen räumlichen Anordnung der Gehäuseteile 10, 9 zueinander eine Nut/Feder-Verbindung möglich ist. Im dargestellten Ausführungsbeispiel ist dabei die Aufnahme 15 für die Verbindungsschraube 16 mit der Nut 25 versehen, während die Feder 26 im Bereich der Gewindebohrung 14 am Gehäuseteil 9 angeordnet ist. Die Nut 25 ist ein integraler Bestandteil der Aufnahme 15 für die Verbindungsschraube 16, die Feder 26 ist ein integraler Bestandteil der Wandung 19 des Gehäuseteiles 9. Im übrigen ist aus Gründen der zeichnerischen Darstellung in Fig. 3 der Dichtring 17 nicht eingezeichnet.

Von besonderer Bedeutung ist bei dem Ausführungsbeispiel nach Fig. 3 die Tatsache, daß hier die Verbindungsschraube 16 als Hohlschraube mit in Längsrichtung verlaufender Durchgangsbohrung 27 ausgeführt ist. Über die Durchgangsbohrung 27 ist das Einstellelement 22 des Bauelementes 21 jederzeit zugänglich, bedarf es insbesondere zur Betätigung des Einstellelementes 22 des Bauelementes 21 nicht mehr eines Entfernens der Verbindungsschraube 16. Aus diesem Grunde sind hier auch ergänzende Verbindungselemente nicht vorgesehen.

/
Gesthuysen & von Rohr

Patentansprüche:

1. Schaltgerät, insbesondere elektronisches, berührungslos arbeitendes Schaltgerät, bestehend aus einem im wesentlichen zylindrischen Gehäuse, aus in dem Gehäuse vorgesehenen und zu einer elektrischen Schaltung miteinander verbundenen elektrischen und/oder elektronischen Bauelementen, zu denen mindestens ein Beeinflussungselement gehört, und ggf. aus einer Anschlußeinrichtung zum Anschluß eines Kabels, wobei das Gehäuse einen Beeinflussungsbereich, einen Schaltungsbereich und einen Anschlußbereich aufweist und aus mindestens zwei Gehäuseteilen besteht, wobei die Gehäuseteile einander zugewandte, unter einem spitzen Winkel zur Gehäuselängsachse verlaufende Begrenzungsflächen aufweisen und wobei ein Gehäuseteil im Bereich der einander zugewandten Begrenzungsflächen eine senkrecht zur Begrenzungsfläche stehende Gewindebohrung und das andere Gehäuseteil eine Aufnahme für eine in die Gewindebohrung einzuschraubende Verbindungsschraube aufweist, d a d u r c h   g e k e n n z e i c h - n e t , daß die Gewindebohrung (14) durch die Wandung (19) des entsprechenden Gehäuseteiles (9) hindurchgeführt ist, daß an dem dem Inneren des Gehäuseteiles (9) zugewandten Ende (20) der Gewindebohrung (14) ein elektrisches oder elektronisches, einstellbares bzw. abstimmbares Bauelement (21) der elektrischen Schaltung (2) angeordnet ist, daß das Bauelement (21) ein Einstellelement (22) aufweist und daß das Einstellelement (22) durch die Gewindebohrung (14) hindurch betätigbar ist.

2. Schaltgerät nach Anspruch 1, dadurch gekennzeichnet, daß das Bauelement (21) ein Potentiometer und das Einstellelement (22) des Bauelementes (21) eine Einstellschraube ist.

3. Schaltgerät nach Anspruch 1 oder 2, dadurch gekennzeichnet, daß das Einstellelement (22) des Bauelementes (21) in die Gewindebohrung (14) hineinragt.

4. Schaltgerät nach einem der Ansprüche 1 bis 3, dadurch gekennzeichnet, daß über das Bauelement (21) das Innere des Gehäuseteiles (9) gegenüber der Gewindebohrung (14) abgedichtet ist.

Gesthuysen & von Rohr

5. Schaltgerät nach Anspruch 4, dadurch gekennzeichnet, daß zwischen dem Bauelement und der Wandung des Gehäuseteiles im Bereich um das Ende der Gewindebohrung herum ein Dichtring angeordnet ist.

6. Schaltgerät nach Anspruch 4, dadurch gekennzeichnet, daß das Bauelement (21) mit der Wandung (19) des Gehäuseteiles (9) im Bereich um das Ende (20) der Gewindebohrung (14) herum verklebt ist.

7. Schaltgerät nach einem der Ansprüche 1 bis 6, dadurch gekennzeichnet, daß an den Gehäuseteilen (9, 10) im Bereich der einander zugewandten Begrenzungsflächen (12, 13) ergänzende Verbindungselemente (24) vorgesehen sind.

8. Schaltgerät nach Anspruch 7, dadurch gekennzeichnet, daß die Verbindungselemente (24) als koaxial zu der Gewindebohrung (14) und der Aufnahme (15) für die Verbindungsschraube (16) angeordnete Rastelemente ausgeführt sind.

9. Schaltgerät nach einem der Ansprüche 1 bis 8, dadurch gekennzeichnet, daß die Verbindungsschraube (16) als Hohlschraube mit in Längsrichtung verlaufender Durchgangsbohrung (27) ausgeführt ist.

Fig.1

Fig.2

Fig.3

0075112